# EUROPÄISCHE PATENTSCHRIFT

(11) **EP 0 422 732 B1**
(45) Veröffentlichungstag und Bekanntmachung des Hinweises auf die Patenterteilung: **21.08.1996**
(21) Anmeldenummer: 90202663.2
(22) Anmeldetag: 05.10.1990
(51) Int. Cl.: H03K 5/08, G01P 3/48, G01R 23/00

(54) **Adaptive Vorrichtung zur Identifikation eines periodischen Signals**
Adaptive apparatus for identification of a periodic signal
Appareil adaptif pour l'identification d'un signal périodique

(30) Priorität: 10.10.1989 DE 3933801
(43) Veröffentlichungstag der Anmeldung: 17.04.1991
(73) Patentinhaber: Philips Patentverwaltung GmbH, 22335 Hamburg (DE); Philips Electronics N.V., 5621 BA Eindhoven (NL)
(72) Erfinder: Muth, Mathias, W-2093 Stelle (DE)
(74) Vertreter: Hartmann, Heinrich, Dipl.-Ing.

(56) Entgegenhaltungen:
- EP-A- 0 220 547
- EP-A- 0 267 072
- EP-A- 0 288 119
- EP-A- 0 360 885
- EP-A- 0 412 618
- FR-A- 2 537 803
- JP-A-63 107 219
- JP-A-63 167 519

## Beschreibung

Die Erfindung betrifft eine adaptive Vorrichtung zur Identifikation eines periodischen Signals mit einer Auswerteschaltung zur Digitalisierung des Signals und zur Detektion der Extremwerte desselben sowie nachgeordneten Mitteln zur Detektion der Grundschwingung des Signals.

Derartige Vorrichtungen dienen zur Identifikation periodischer Signale unbekannter Frequenz, Amplitude und Offsetlage, sowie Eindellungen der Amplitude im Bereich ihrer Extremwerte. Diese Parameter des zu identifizierenden Signals, nachfolgend auch kurz Signal genannt, sind überdies noch zeitlichen Änderungen unterworfen. Beispielhaft für derartige Signale sind die von Drehzahlsensoren, die z.B. bei Antiblockiersystmen, Antischlupfsysstemen usw. einggesetzt werden. Derartige Drehzahlsensoren liefern in der Regel ein relativ kleines, wechselndes Sensorsignal, das mit einer Gleichspannung überlagert ist. Über einen nachgeordneten Komparator wird dieses wechselnde, mit Schwankungen behaftete Sensorsignal in der Regel digitalisiert, d.h. in ein entsprechendes Rechtecksignal gewandelt und einer weiteren Auswertung zugeführt.

Identifikations- bzw. Meßvorrichtungen dieser Art sind bekannt. Sie weisen in der Regel ein Zahnrad auf, dessen Drehzahlsignal über beispielsweise einen magnetisch arbeitenden Drehzahlsensor abgetastet wird. Aus der EP-A 0412 618, die zum Stand der Technik nach Art. 54(3) EPÜ gehört, ist eine entsprechende Vorrichtung bekannt, die Mittel zum Verstärken, Vergleichen und Auswerten des Sensorsignals des Drehzahlsensors zur Erzeugung eines dementsprechenden digitalen Ausgangssignals aufweist. Das Signal soll nach dieser Vorrichtung dadurch eindeutig identifiziert und ausgewertet werden, daß ein Fensterkomparator mit beeinflußbarem Fenster als Mittel zum Vergleichen vorgesehen ist, der über mindestens ein logisches Schaltglied ein Flip-Flop zur Abgabe des Ausgangssignals ansteuert und dem Mittel nachgeordnet sind, die abhängig von der Offsetlage fortlaufend entsprechende Referenzsignale für den Fensterkomparatur erzeugen. Die Vergleichs- und Auswerteeinrichtungen dieser vorbekannten Vorrichtung weisen ferner einen Oszillator letztlich zum Anpassen des Fensterbereiches an das zu identifizierende Signal auf. Für den Fall, daß das Signal in den Bereichen seiner Extremwerte eingedellt ist, ist entsprechend dieser vorbekannten Vorrichtung eine Oszillatorfrequenz vorgesehen, die nicht wesentlich größer ist als die Frequenz des Signals, so daß das Fenster des Fensterkomparators dem Signal nicht mehr folgt, sondern nur noch nachläuft, wobei das Maß des Nachlaufens durch die Oszillatorfrequenz begrenzt ist. Bei niedrigen Frequenzen des Signals wird dem Signal auch im Bereich der Eindellungen gefolgt, wodurch diese bekannte Vorrichtung gegenüber Eindellungen des zu identifizierenden Signals im Bereich seiner Extremwerte nicht hinreichend robust ist.

Aus der EP-A 0 267 072 ist eine Anordnung zur Identifikation eines periodischen Signals und zur Störunterdrückung bekannt. Dabei wird ein Vergleichswert aus gespeicherten Extremwerten des Eingangssignals berechnet und mit dem Eingangssignal verglichen. Der schaltungstechnische Aufwand insbesondere an Speicherbausteinen ist hierbei jedoch sehr groß.

Aus der JP-A 63 107219 und aus der JP-A 63 167519 sind einfache analoge Schaltungen zur Erkennung eines periodischen Signals bekannt. Bei größeren Schwingungen ist damit jedoch eine Detektion der Grundschwingung nicht möglich.

Der vorliegenden Erfindung liegt die Aufgabe zugrunde, eine adaptive Vorrichtung zur Identifikation eines periodischen Signals zu schaffen, die auch bei großen Offset-Spannungstoleranzen, Verschiebungen und Eindellungen ein zur Grundschwingung des Signals proportionales Ausgangssignal erzeugt und einen einfachen und gegen sonstige Störungen robusten Aufbau aufweist.

Erfindungsgemäß wird diese Aufgabe dadurch gelöst, daß die nachgeordneten Mittel eine Mittelwertschaltung und einen Vergleicher aufweisen und daß der Vergleicher in Abhängigkeit der Übereinstimmung des digitalisierten Signals mit einer Vergleichsgröße, die von der Mittelwertschaltung rekursiv aus sich selbst und aus den Extremwerten des digitalisierten Signals gebildet wird, ein sich änderndes, der Grundschwingung des Signals proportionales Ausgangssignal erzeugt.

Die erfindungsgemäße Vorrichtung weist im wesentlichen eine Auswerteschaltung, eine Mittelwertschaltung und einen Vergleicher auf. Die Auswerteschaltung weist einen Analog-/Digital-Wandler nach dem Kompensationsverfahren mit einer Zähleinrichtung (nachfolgend auch kurz A/D-Wandler genannt), an dessen Eingang das zu indentifizierende Signal anliegt, und ein nachgeordnetes Extremwerterkennungsglied auf, welches ausgangsseitig mit der Mittelwertschaltung verbunden ist und dieser ein Taktsignal in Abhängigkeit des Erreichens eines Extremwertes zuführt. Der Ausgang des A/D-Wandlers ist mit der Mittelwertschaltung und dem Vergleicher verbunden. Der analoge Eingang des A/D-Wandlers ist mit dem Extremwerterkennungsglied verbunden, welches aus einem Vergleich des analogen Eingangssignals und dem diesen entsprechenden digitalisierten Signal die Extremwerte ermittelt.

Liegt im Idealfall ein störungsfreies, sinusförmiges Eingangssignal am Eingang der Auswerteschaltung an, dann ermittelt diese zunächst, ob das Signal einen Extremwert, also ein Maximum oder ein Minimum durchlaufen hat. Diese Punkte werden mit Hilfe des A/D-Wandlers nach dem Kompensationsverfahren dadurch ermittelt, daß sich die Zählrichtung des Wandlers nach einem Extremwert umkehrt. In vorteilhafter Weise erfolgt die Detektion eines Extremwertes in der Auswerteschaltung erst beim Erreichen einer vorgebbaren Mindestumkehrspannung nach einem Extremwert.

Durch dieses Nachlaufen werden bereits kleinere Störungen des Eingangssignals kompensiert. Der Betrag der Mindestumkehrspannung bestimmt somit letztlich auch die unterste detektierbare Eingangsamplitude. Das Ausgangssignal leitet sich dann aus der Zählrichtung des Wandlers ab.

Möglicherweise auftretende Oberschwingungen, insbesondere bei Signalen eines Magnetfeldsensors die dritte harmonische Oberschwingung, liegen häufig innerhalb der Schaltungsempfindlichkeit. Die Auswirkungen dieser Oberschwingungen, nämlich Eindellungen im Bereich der Extremwerte des Signals werden erfindungsgemäß letztlich als Fehler erkannt und unterdrückt.Die nachgeordnete Mittelwertschaltung weist vorteilhaft ein Addierglied, ein Divisionsglied und ein Speicherglied in einer Reihenschaltung auf, wobei das Ausgangssignal des Speicherglieds als Vergleichsgröße dem Vergleicher zugeführt wird und auf den Eingang des Addierglieds rückgekoppelt ist, wobei das Addierglied eingangsseitig ferner mit dem Ausgang des A/D-Wandlers verbunden ist. Das Speicherglied erhält vorzugsweise Taktimpulse vom Ausgang des Extremwerterkennungsglieds.

Entsprechend einer vorteilhaften Ausgestaltung der Erfindung bildet das Addierglied kontinuierlich die Summe aus seinen Eingangssignalen. Das nachgeordnete Divisionsglied dividiert die Summe durch zwei und das diesem nachgeordnete Speicherglied speichert im Zeitpunkt eines Taktimpulses den dann anstehenden Signalwert ab und gibt ihn ausgangsseitig an den Eingang des Vergleichers als Vergleichsgröße sowie eingangsseitig an das Addierglied weiter.

Alle Extremwerte, so auch die der Oberschwingungen, werden somit einer rekursiven Mittelwertbildung zugeführt. D.h. es wird im Zeitpunkt eines detektierten Extremwerts der aktuelle digitale Signalwert des A/D-Wandlers quasi zum Inhalt des Speicherglieds addiert. Das Additionsergebnis gelangt dann, nachdem es durch zwei dividiert wurde, als neuer Signalwert in den Speicher und repräsentiert den aktuellsten, dem Meßsignal nachlaufenden Signalmittelwert, also die Vergleichsgröße.

Erfindungsgemäß ist der Vergleicher eingangsseitig mit dem Ausgang des A/D-Wandlers und dem Speicherglied der Mittelwertschaltung verbunden und erzeugt im Zeitpunkt der Identität der ihm zugeführten Signale ein digitales Ausgangssignal, das der Grundschwingung des zu identifizierenden Signals proportional ist.

Ferner kann vorteilhaft eine Ladeschaltung vorgesehen sein, die das Speicherglied bei Inbetriebnahme der Vorrichtung mit dem anliegenden Signalwert lädt, da anderenfalls, bespielsweise bei einem Wert Null im Speicherglied, einige Perioden zur Annäherung der Vergleichsgröße an das Signal benötigt werden.

Weitere bevorzugte Ausgestaltungen der erfindungsgemäßen Vorrichtung ergeben sich aus den Unteransprüchen.

Ein Ausführungsbeispiel der Erfindung wird nachfolgend unter Bezugnahme auf eine Zeichnung näher erläutert. Es zeigt:
- Fig. 1: ein Ausgangssignal U_{A} einer erfindungsgemäßen Vorrichtung anhand eines nicht eingedellten Signals U_{S} unter Berücksichtigung einer Mindestumkehrspannung U_{M},
- Fig. 2: ein fehlerhaftes Ausgangssignal U_{A} einer Vorrichtung ohne Mittelwertschaltung bei Signaloberschwingungen innerhalb der Schaltungsempfindlichkeit,
- Fig. 3: das Blockschaltbild einer erfindungsgemäßen Vorrichtung mit einer Mittelwertschaltung, und
- Fig. 4: ein Ausgangssignal U_{A} einer erfindungsgemäßen Vorrichtung mit Mittelwertschaltung bei Signaloberschwingungen innerhalb der Schaltungsempfindlichkeit.

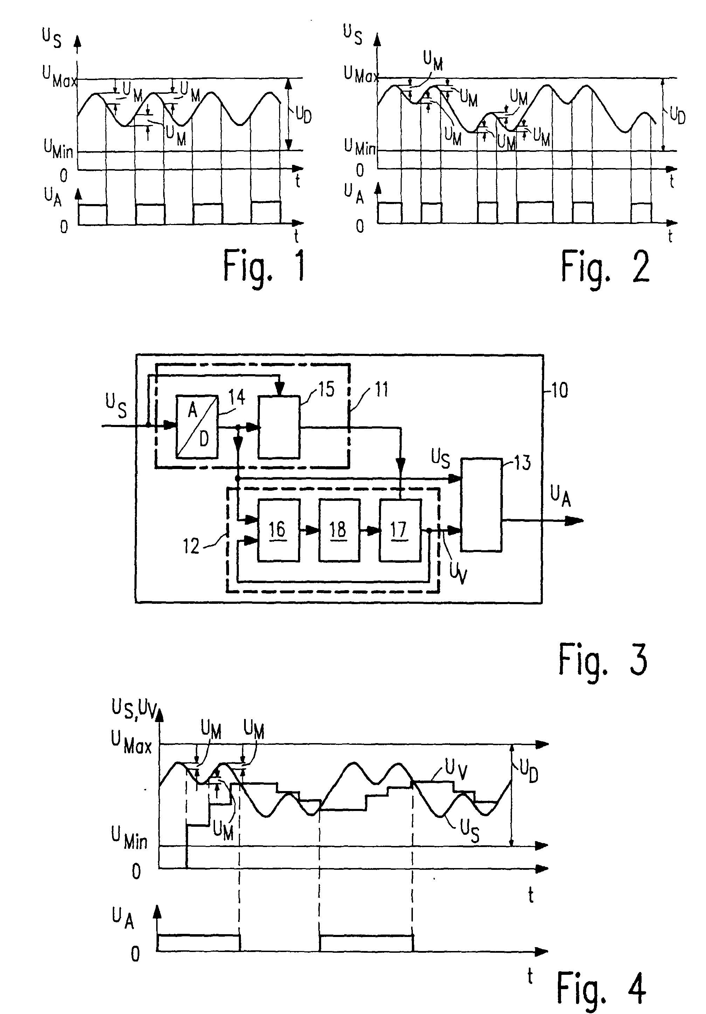

Fig. 1 zeigt zwei Diagramme. Im oberen ist das zu identifizierende Signal U_{S} über der Zeit t und im darunter befindlichen eine digitale Ausgangsspannung U_{A} anhand eines idealen sinusförmigen ungestörten Signals U_{S} dargestellt. Das zu identifizierende Signal U_{S} ist aus der Null-Lage heraus nach oben verschoben. Diese Verschiebung wird durch den zulässigen Arbeitsbereich U_{D} einer erfindungsgemäßen, in Fig. 3 prinzipiell dargestellten Vorrichtung 10 durch ein unteres zulässiges Signal U_{Min} und ein oberes zulässiges Signal U_{Max} berücksichtigt. Das in Fig. 1 dargestellte, zu identifizierende Signal U_{S} ist beispielsweise das ausgangsseitige Signal eines magnetisch arbeitenden Drehzahlaufnehmers eines Antiblockier-, Antischlupfsystems o.dgl. und liegt eingangsseitig an der erfindungsgemäßen Vorrichtung an. Wie Fig. 1 zu entnehmen ist und weiter unten im einzelnen erläutert ist, werden die Impulse zur Erzeugung des Ausgangssignals U_{A} nicht exakt beim Erreichen der Extremwerte des Signals U_{S} gesetzt, sondern laufen diesen Extremwerten zeitlich nach. Durch eine wählbare Mindestumkehrspannung U_{M} läßt sich dieses Nachlaufen beeinflußen. Störungen des Signals U_{S}, die betragsmäßig innerhalb der Mindestumkehrspannung U_{M} liegen, können hierdurch bereits kompensiert werden. Die Mindestumkehrspannung U_{M} bestimmt gleichzeitig die unterste detektierbare Amplitude des zu identifizierenden Signals U_{S}, und ist hierdurch in seiner Größe beschränkt, d.h. die Mindestumkehrspannung U_{M} ist betragsmäßig kleiner als betragsmäßig die doppelte Amplitude des Signals U_{S}.

An dieser Stelle sei darauf hingewiesen, daß die zuvor für Fig. 1 angegebene Beschreibung der Diagramme hinsichtlich der dargestellten Größen im wesentlichen auch für die Diagramme in den Fig. 2 und 4 gilt. Ferner sei darauf hingewiesen, daß die in den Fig. 1, 2 und 4 dargestellten, zu identifizierenden Signale U_{S} sowohl den analogen als auch den näherungsweise digitalen Verlauf dieser Signale repräsentieren.

In Fig. 2 ist ein gestörter Verlauf des Signals U_{S} dargestellt, bei dem Oberschwingungen des Signals U_{S} Eindellungen desselben im Bereich seiner Extremwerte verursachen. Beispielsweise liefert ein Magnetfeldsensor eines Drehzahlaufnehmers bei ungünstigen Sensorrädern neben der Grundschwingung noch die 3. harmonische Oberschwingung. Die 3. Oberschwingung liegt innerhalb der Empfindlichkeit der Vorrichtung, d.h. die dadurch verursachten Eindellungen sind betragsmäßig größer als die Mindestumkehrspannung U_{M} und erzeugen somit ein fehlerhaftes Ausgangssignal U_{A}, wie es das untere Diagramm in Fig. 2 zeigt.

Damit auch derartige Störeinflüsse durch Oberschwingungen sicher vermieden werden, weist die erfindungsgemäße Vorrichtung 10 gemäß Fig. 3 eine Auswerteschaltung 11 und eine Mittelwertschaltung 12 sowie einen Vergleicher 13 auf, an dessen Ausgang ein sich änderndes, nur noch der Grundschwingung des Signals U_{S} proportionales Ausgangssignal U_{A} vorliegt. Das analoge Signal U_{S} wird dazu einem A/D-Wandler 14 der Auswerteschaltung 11 zugeführt und von diesem digitalisiert und dieses digitalisierte Signal U_{S} an ein Extremwerterkennungsglied 15 der Auswerteschaltung 11, den Vergleicher 13 und an den Eingang eines Addiergliedes 16 der Mittelwertschaltung 12 übergeben. Über einen Steueranschluß ist das analoge Signal U_{S} ferner mit dem Extremwerterkennungsglied 15 verbunden. In der Auswerteschaltung 11 wird das digitalisierte Signal U_{S} daraufhin analysiert, ob es ein Maximum bzw. Minimum durchlaufen hat. Diese Punkte werden mit Hilfe des A/D-Wandlers 14 nach dem Kompensationsverfahren dadurch ermittelt, daß sich die Zählrichtung des A/D-Wandlers 14 nach Durchlaufen eines Extremwertes umkehrt. Wie bereits erwähnt, werden dabei kleine Störungen des Signals kompensiert, indem erst auf eine Mindestumkehrspannung U_{M} nach dem Durchlaufen eines Minimums bzw. Maximums reagiert wird.

Für den Fall, daß die Eindellungen durch eine Störung betragsmäßig kleiner sind als die Mindestumkehrspannung U_{M}, kann, gemäß einer bevorzugten Ausgestaltung der Erfindung, bereits das am Ausgang des Extremwerterkennungsglieds 15 erzeugte Signal als fehlerfreies Ausgangssignal weiter verarbeitet werden. Sind die Störungen jedoch größer, wie etwa in Fig. 2 dargestellt, dann ist erfindungsgemäß vorgesehen, daß das am Ausgang des Extremwerterkennungsglieds 15 anstehende Signal als Taktsignal bzw. Ladeimpulssignal einem Speicherglied 17 der Mittelwertschaltung 12 zugeführt wird. Das Speicherglied 17 erhält die zu speichernden Signalwerte von einem vorgeschalteten Divisionsglied 18, das wiederum dem Addierglied 16 nachgeordnet ist und gibt den gespeicherten Signalwert sowohl an den Vergleicher 13 als Vergleichsgröße U_{V} als auch über einen Rückkopplungszweig an den Eingang des Addierglieds 16 ab. Durch diese Verknüpfung innerhalb der Mittelwertschaltung 12 kann eine rekursive Mittelwertbildung durchgeführt werden. Denn das digitalisierte Signal U_{S} steht als Signalwert am Eingang des Addierglieds 16 zur Verfügung, ebenso wie der Signalwert des Speicherglieds 17 entsprechend dem vorangegangenen Ladeimpuls, d.h. entsprechend dem letzten Extremwert. Das Addierglied 16 bildet ständig die Summe aus den eingangs anstehenden Signalwerten. Im nachgeordneten Divisionsglied 18 wird diese Summe durch zwei dividiert, so daß diese Funktion nahezu in Echtzeit am Eingang des Speichers zur Verfügung steht. Wird nun ein neuer Ladeimpuls seitens des Extremwerterkennungsglieds 15 auf das Speicherglied 17 gegeben, dann wird der entsprechende Funktionswert des Signals U_{S} als neuer Signalwert im Speicherglied 17 abgespeichert und dem Vergleicher 13 sowie dem Addierglied 16 eingangsseitig zugeführt.

Der Vergleicher 13 benutzt dieses vom Speicherglied 17 herrührende Vergleichssignal U_{V} und vergleicht es mit dem digitalisierten Signal U_{S}, das ihm ebenfalls als Eingangssignal über den A/D-Wandler 14 zur Verfügung steht. Jeweils zu dem Zeitpunkt, in dem die Eingangssignale des digitalen Vergleichers 13 sich entsprechen, erzeugt dieser eine Änderung seines Ausgangszustandes, wodurch das Ausgangssignal U_{A} der erfindungsgemäßen Vorrichtung gebildet wird.

Bildlich gesprochen ermittelt der Vergleicher 13 die in Fig. 4 dargestellten Schnittpunkte des digitalisierten Signals U_{S} und des diesem U_{S} nacheilenden, treppenförmigen Vergleichssignals U_{V}, also wie es am Ausgang der Mittelwertschaltung 12 zur Verfügung steht. Wie die Fig. 4 zeigt, sind die Schnittpunkte dieser beiden Kurven proportional zur Grundschwingung des Signals U_{S}, ohne daß störende Oberschwingungen Einfluß auf das Ausgangsignal U_{A} haben.

Wie bereits eingangs erwähnt, ist in Fig. 4 vereinfachend der Verlauf des analogen Signals U_{S} dargestellt, obgleich es sich tatsächlich um das vom A/D-Wandler 14 digitalisierte Signal U_{S} handelt. Enthält das Speicherglied 17 beispielsweise zu Beginn einer Identifikation den Wert Null, dann kann, wie dies über das treppenförmige Vergleichssignal U_{V} in Fig. 4 angedeutet ist, dies bei kleinen Signalen U_{S} mit großem Offset zur Unterdrückung einiger Anfangsperioden führen, da der Inhalt des Speicherglieds 17 sich erst dem Eingangssignal U_{S} nähern muß. Durch eine nicht dargestellte Ladeschaltung kann erfindungsgemäß der Speicher des Speicherglieds 17 bei Inbetriebnahme der Vorrichtung mit dem momentanen digitalisierten Signal U_{S} geladen werden, wodurch ein schnelles Anlaufen der erfindungsgemäßen Vorrichtung möglich ist.

Hier sei angemerkt, daß alle genannten Signalwerte bzw. Signalgrößen vorteilhaft elektrische Spannungen sind.

Die in der vorstehenden Beschreibung, in den Fig. 1, 2, 3 und 4 sowie in den Ansprüchen offenbarten Merkmale der Erfindung können sowohl einzeln als auch in beliebiger Kombination für die Verwirklichung der Erfindung in ihren verschiedenen Ausführungsformen wesentlich sein.

## Patentansprüche

1. Adaptive Vorrichtung zur Identifikation eines periodischen Signals mit einer Auswerteschaltung zur Digitalisierung des Signals und zur Detektion der Extremwerte desselben sowie nachgeordneten Mitteln zur Detektion der Grundschwingung des Signals, dadurch gekennzeichnet, daß die nachgeordneten Mittel (12, 13) eine Mittelwertschaltung (12) und einen Vergleicher (13) aufweisen, und daß der Vergleicher (13) in Abhängigkeit der Übereinstimmung des digitalisierten Signals (U_{S}) mit einer Vergleichsgröße (U_{V}), die von der Mittelwertschaltung (12) rekursiv aus sich selbst und aus den Extremwerten des digitalisierten Signals (U_{S}) gebildet wird, ein sich änderndes, der Grundschwingung des Signals (U_{S}) proportionales Ausgangssignal (U_{A}) erzeugt.

2. Vorrichtung nach Anspruch 1, dadurch gekennzeichnet, daß die Auswerteschaltung (11) einen Analog/Digital-Wandler (14), an dessen Eingang das zu identifizierende Signal (U_{S}) anliegt und ein nachgeordnetes Extremwerterkennungsglied (15) aufweist, welches ausgangsseitig mit der Mittelwertschaltung (12) verbunden ist und dieser ein Taktsignal, d.h. ein Ladesignal in Abhängigkeit des Erreichens eines Extremwertes zuführt, und daß der Ausgang des A/D-Wandlers (14) mit der Mittelwertschaltung (12) und dem Vergleicher (13) verbunden ist.

3. Vorrichtung nach Anspruch 2, dadurch gekennzeichnet, daß die Auswerteschaltung (11) die Extremwerte nach einem Kompensationsverfahren dadurch detektiert, daß die Zählrichtung einer Zähleinrichtung des A/D-Wandlers (14) sich nach einem Extremwert umkehrt und das digitale Ausgangssignal des Extremwerterkennungsglieds (15) seinen Zustand in Abhängigkeit der Zählrichtung des A/D-Wandlers (14) und einer vorgebbaren Mindestumkehrspannung (U_{M}) ändert.

4. Vorrichtung nach Anspruch 3, dadurch gekennzeichnet, daß die Mindestumkehrspannung (U_{M}) kleiner ist als die doppelte Amplitude des zu identifizierenden Signals (U_{S}), und daß das Extremwerterkennungsglied (15) seinen Ausgangszustand erst ändert, wenn nach einem Extremwert des Signals (U_{S}) die Signalwertänderung er Mindestumkehrspannung (U_{M}) entspricht.

5. Vorrichtung nach einem oder mehreren der vorhergehenden Ansprüche, dadurch gekennzeichnet, daß die Mittelwertschaltung (12) ein Addierglied (16), ein Divisionsglied (18) und ein Speicherglied (17) in einer Reihenschaltung aufweist, wobei das Ausgangssignal des Speicherglieds (17) dem Vergleicher (13) als Vergleichsgröße (U_{V}) zugeführt wird und auf den Eingang des Addierglieds (16) rückgekoppelt ist, der mit dem Ausgang des A/D-Wandlers (14) verbunden ist, und daß das Speicherglied (17) für Taktimpulse bzw. Ladeimpulse mit dem Ausgang des Extremwerterekennungsglieds (15) verbunden ist.

6. Vorrichtung nach Anspruch 5, dadurch gekennzeichnet, daß das Addierglied (16) kontinuierlich die Summe seiner Eingangssignale (U_{S}), (U_{V}) bildet, das Divisionsglied (18) diesen Summenwert durch zwei dividiert und im Zeitpunkt eines Taktimpulses das Speicherglied (17) den jeweils anstehenden Signalwert speichert und ausgangsseitig als aktuelle Vergleichsgröße (U_{V}) zur Verfügung stellt.

## Claims

1. An adaptive arrangement for the identification of a periodic signal, comprising an evaluation circuit for digitizing the signal and for detecting its extreme values, as well as subsequent means for detecting the fundamental oscillation of the signal, characterized in that the subsequent means (12, 13) include a mean value circuit (12) and a comparator (13) and that, depending on whether the digitized signal (U_{S}) corresponds to a reference value (U_{V}), recursively formed by the mean value circuit (12) from itself and from the extreme values of the digitized signal (U_{S}), the comparator (13) produces a varying output signal (U_{A}) which is proportional to the fundamental oscillation of the signal (U_{S}).

2. An arrangement as claimed in Claim 1, characterized in that the evaluation circuit (11) includes an analog/digital converter (14) whose input carries the signal (U_{S}) to be identified and also includes a subsequent extreme value recognition member (15) having an output which is connected to the mean value circuit (12) whereto it applies a clock signal, i.e. loading signal, in dependence on whether an extreme value is reached, and that the output of the A/D converter (14) is connected to the mean value circuit (12) and to the comparator (13).

3. An arrangement as claimed in Claim 2, characterized in that the evaluation circuit (11) detects the extreme values in conformity with a compensation method in that the direction of counting of a counter device of the A/D converter (14) is reversed after an extreme value and the digital output signal of the extreme value recognition member (15) changes its state in dependence on the counting direction of the A/D converter (14) and a presettable minimum reversing voltage (U_{M}).

4. An arrangement as claimed in Claim 3, characterized in that the minimum reversing voltage (U_{M}) is less than twice the amplitude of the signal (U_{S}) to be identified, and that the extreme value recognition member (15) does not change its output state until the signal value change corresponds to the minimum reversing voltage (U_{M}) after and extreme value of the signal (U_{S}).

5. An arrangement as claimed in one or more of the preceding Claims, characterized in that the mean value circuit (12) comprises a series connection of an adder member (16), a divider member (18) and a storage member (17), the output signal of the storage member (17) being applied as a reference value (U_{V}) to the comparator (13) and being fed back to the input of the adder member (16) which is connected to the output of the A/D converter (14), and that for clock pulses or loading pulses the storage member (17) is connected to the output of the extreme value recognition member (15).

6. An arrangement as claimed in Claim 5, characterized in that the adder member (16) continuously forms the sum of its input signals (U_{S}), (U_{V}), that the divider member (18) divides this sum value by two and that at the instant at which a clock pulse occurs the storage member (17) stores the signal value then present and outputs it as the actual reference value (U_{V}).

## Revendications

1. Dispositif adaptatif pour l'identification d'un signal périodique avec un circuit d'évaluation pour la numérisation du signal et la détection de ses valeurs extrêmes, ainsi que des moyens en aval pour la détection de la composante fondamentale du signal, caractérisé en ce que les moyens (12, 13) montés en aval présentent un circuit de calcul de moyenne (12) et un comparateur (13), et en ce que le comparateur (13) produit un signal de sortie (U_{A}) variable, proportionnel à la composante fondamentale du signal (U_{S}) en fonction de la conformité du signal numérisé (U_{S}) avec une grandeur de comparaison (U_{V}) qui est formée de manière récurrente par le circuit de calcul de moyenne (12) à partir de lui-même et des valeurs extrêmes du signal numérisé (U_{S}).

2. Dispositif selon la revendication 1, caractérisé en ce que le circuit d'évaluation (11) présente un convertisseur analogique/numérique (14) à l'entrée duquel est appliqué le signal à identifier (U_{S}) et un circuit de reconnaissance de valeurs extrêmes (15) monté en aval, qui est relié côté sortie au circuit de calcul de moyenne (12) et amène à celui-ci un signal de synchronisation, c'est-à-dire un signal de charge en fonction du passage d'une valeur extrême, et en ce que la sortie du convertisseur A/N (14) est reliée au circuit de calcul de moyenne (12) et au comparateur (13).

3. Dispositif selon la revendication 2, caractérisé en ce que le circuit d'évaluation (11) détecte les valeurs extrêmes après un procédé de compensation par le fait que le sens de comptage d'un dispositif de comptage du convertisseur A/N (14) s'inverse après une valeur extrême et en ce que le signal de sortie numérique du circuit de reconnaissance de la valeur extrême (15) change d'état en fonction du sens de comptage du convertisseur A/N (14) et d'une tension de claquage minimale prédéterminée (U_{M}).

4. Dispositif selon la revendication 3, caractérisé en ce que la tension de claquage minimale (U_{M}) est inférieure au double de l'amplitude du signal à identifier (U_{S}), et en ce que le circuit de reconnaissance des valeurs extrêmes (15) ne change d'état de sortie que lorsque le changement de la valeur du signal correspond à la tension de claquage minimale (U_{M}) après une valeur extrême du signal (U_{S}).

5. Dispositif selon l'une ou plusieurs des revendications précédentes, caractérisé en ce que le circuit de calcul de moyenne (12) présente un circuit additionneur (16), un circuit diviseur (18) et un circuit de mémoire (17) dans un montage en série, le signal de sortie du circuit de mémoire (17) est amené au comparateur (13) comme grandeur de comparaison (U_{V}) et est réinjecté à l'entrée du circuit additionneur (16) qui est relié à la sortie du convertisseur A/N (14), et en ce que le circuit de mémoire (17) est relié pour les impulsions de synchronisation ou les impulsions de charge à la sortie du circuit de reconnaissance de valeurs extrêmes (15).

6. Dispositif selon la revendication 5, caractérisé en ce que le circuit additionneur (16) forme en continu la somme de ses signaux d'entrée (U_{S}), (U_{V}), le circuit diviseur (18) divise par deux la valeur de la somme et sauve la valeur de signal respectivement présente au moment d'une impulsion de synchronisation et la met à disposition côté sortie comme grandeur de comparaison actuelle (U_{V}).
